# EUROPÄISCHE PATENTSCHRIFT

(11) **EP 1 513 204 B1**
(45) Veröffentlichungstag und Bekanntmachung des Hinweises auf die Patenterteilung: **13.12.2006**
(21) Anmeldenummer: 03400052.1
(22) Anmeldetag: 08.09.2003
(51) Int. Cl.: H01L 39/14, H01L 39/24, C30B 29/22, C30B 9/00

(54) **Hochtemperatursupraleitendes Bauteil und Verfahren zu dessen Herstellung**
High-temperature superconducting device and method of manufacturing same
Dispositif supraconducteur à haute température et procédé de sa fabrication

(30) Priorität: 06.09.2002 DE 10241759
(43) Veröffentlichungstag der Anmeldung: 09.03.2005
(73) Patentinhaber: Leibniz-Institut für Festkörper- und Werkstoffforschung Dresden e.V., 01069 Dresden (DE)
(72) Erfinder: Krabbes, Gernot, Prof. Dr., 01809 Heidenau (DE); Hopfinger, Thomas, Dr., 01099 Dresden (DE)
(74) Vertreter: Rauschenbach, Dieter

(56) Entgegenhaltungen:
- DE-A1- 10 111 778
- DE-U1- 29 723 453
- US-B1- 6 256 521
- US-B1- 6 258 754
- JEE Y A ET AL: "Top-seeded melt growth of Y-Ba-Cu-O superconductor with multiseeding" SUPERCONDUCTOR SCIENCE & TECHNOLOGY IOP PUBLISHING UK, Bd. 13, Nr. 2, Februar 2000 (2000-02), Seiten 195-201, XP002338237 ISSN: 0953-2048
- HOPFINGER T ET AL: "Joining of multi-seeded YBCO melt-textured samples using YBCO/Ag composites as welding material" PHYSICA C, NORTH-HOLLAND PUBLISHING, AMSTERDAM, NL, Bd. 398, Nr. 3-4, 15. November 2003 (2003-11-15), Seiten 95-106, XP004468155 ISSN: 0921-4534

## Beschreibung

Die Erfindung betrifft ein hochtemperatursupraleitendes Bauteil und ein Verfahren zu dessen Herstellung. Das Bauteil kann in den verschiedensten geometrischen Formen ausgeführt sein, beispielsweise als ringförmiges Bauteil mit quadratischem oder rechteckigem Querschnitt, als kreisscheibenförmiges Bauteil oder als quaderförmiges Bauteil. Derartige Bauteile können insbesondere in der Energie-, der Antriebs- und der Transporttechnik angewandt werden.

Massive hochtemperatursupraleitende Materialien werden üblicherweise durch eine peritektische Schmelzkristallisation durch Umkehr der Zersetzungsreaktion

α-Supraleiterphase (Massivmaterial) ⇔ Schmelze + β-Festphase

hergestellt, die für YBa₂Cu₃O_{7-δ} (YBCO) als α-Phase an Luft bei 1020°C abläuft (z.B. M. Murakami et al., Journal of Engineering Materials and Technology 114(1992)189-195). Nicht reagierte β-Phase Y₂BaCuO₅ (211) bleibt im Fall von YBCO als Einschluss im Gefüge erhalten. Die diesem Prozess zugrunde liegende Kristallisation verbunden mit einem Temperaturgradienten wird üblicherweise als Schmelztexturierung bezeichnet.

Die so erhaltenen Formkörper werden bei der Anwendung üblicherweise als Einzelstücke verwendet. Bauteile, wie beispielsweise Ringe oder größere Flächen, werden durch Aneinanderlegen dieser Einzelstücke hergestellt. Die für die Anwendungen zum Beispiel in elektrischen Maschinen wichtige Größe der Remanenzinduktion, bei solchen Bauteilen auch als "eingefrorenes Magnetfeld" bezeichnet, ist proportional zum Produkt j_{c} x R, wobei j_{c} die kritische Stromdichte des supraleitenden Materials und R die Ausdehnung des vom supraleitenden Strom durchflossenen Bauteils bedeuten. Im Unterschied zu metallischen Werkstoffen ist ein Stromfluss durch übliche Korngrenzen oder Fügestellen zwischen mehreren Formkörpern in HochT_{c}-Supraleiterbauteilen ausgeschlossen. Im Vergleich zu einem gleich großen einzelnen monolithischen Formkörper, in dem der Ladungsträgertransport über das gesamte Volumen des Formkörpers erfolgt, tritt eine deutliche Reduzierung der elektrischen und magnetischen Eigenschaftsparameter ein.

Es ist bereits bekannt, dass bei Verwendung eines Keimkristalls von diesem ausgehend ein großes Einzelkorn wächst, das sich im Idealfall über das gesamte Volumen des Formkörpers ausdehnt (Morita M., Sawamura M., Takebayashi S., Kimura K., Teshima H., Tanaka M., Miyamoto K. and Hashimoto M. 1994, Physica C, 235-240, 209-212; Schätzle P., Bieger W., Krabbes G., Klosowski J. and Fuchs G., 1995 Inst. Phys. Conf., Ser. No 148, 155-158). Hierbei besitzt das gewachsene Korn die vorgegebene Orientierung des Keimes. Die elektrischen und magnetischen Eigenschaften stehen in definierter Beziehung zur äußeren Geometrie des Formkörpers.

Diese Verfahrensweise ist vorteilhaft nur für Formkörper mit geringen Abmessungen (d < 40 mm) anwendbar, da bei Formkörpern mit größeren Abmessungen die Ausbildung eines Einzelkorns über das gesamte Volumen nicht vollständig stattfindet. Zusätzlich erniedrigen sich die erzielbaren elektrischen und magnetischen Eigenschaften mit zunehmender Abmessung des Formkörpers. Das Wachstum des Einzelkorns verläuft bei großen Abmessungen des Formkörpers mit zunehmendem Abstand vom Keim instabiler, wodurch sekundäre Körner mit beliebiger Orientierung zur äußeren Geometrie des Formkörpers wachsen können.

Dieser nachteilige Einfluss wird üblicherweise dadurch verzögert, dass die Wachstumsgeschwindigkeit vermindert wird. Dies hat jedoch unvertretbar lange Prozesszeiten von mehreren Wochen zur Folge.

Bei der Anwendung solcher Formkörper muß deshalb zur Erzielung großflächiger oder großvolumiger Bauteile eine entsprechende Anzahl Formkörper aneinander- oder zusammengefügt werden. Nachteilig ist dabei jedoch, dass bei einem derartigen Komposit ein Transport der elektrischen Ladungsträger von einem Formkörper zum nächsten über die gemeinsamen Kanten ausgeschlossen ist. Damit verbunden tritt eine deutliche Reduzierung der elektrischen und magnetischen Eigenschaften des Bauteils gegenüber dem einzelnen Formkörper auf.

Bekannt ist es auch, während des Schmelztexturierungsprozesses mehrere Keime aufzulegen, so dass ein Supraleiterkörper entsteht, in dem mehrere Einzelmonolithe vorhanden sind (JP 06-316496, JP 06-316495, JP 08-283091, DE 297 23 453 U1). Die so hergestellten, aus mehreren orientierten Einzelkörnern bestehenden Bauteile zeigen eine deutlich verbesserte supraleitende Stromtragfähigkeit senkrecht zur kristallographischen c-Achse. Sie haben jedoch den Nachteil, dass an den kohärenten Korngrenzen nur ein begrenzter supraleitender Strom fließen kann, bedingt durch gefügebedingte Defekte im Bereich der Verbindungsstellen. Bei den Defekten handelt es sich um Hohlräume und nichtsupraleitende Bestandteile.

Außerdem ist es bekannt, dass eine supraleitende Verbindung zwischen zwei supraleitenden Teilen gleicher Orientierung hergestellt werden kann, wenn die gleichorientierten Teile durch Trennen einer zuvor zusammenhängenden, aus einem einzigen Korn bestehenden Scheibe mittels Verlöten wieder verbunden werden (T. Prikhna et al, Physica C 254 (2001) 333; J Yoshioka et al, Supercond. Sci. Technol. 15 (2002) 712; C. Jooss et al, Physica C 341-348 (2000) 1423). Hierbei wurden als Lot Tm 123, Yb 123 und Er 123 verwendet.

Es ist auch bekannt, mehrkomponentige Lotmaterialien einzusetzen, zum Beispiel solche, die einen Anteil von Ag enthalten (C. Harnois et al, EUCAS Europ. Conf. Applied Supercon., Copenhagen 29.8.2001, to be publ. in Physica C 2002), weil dadurch bei niedrigerer Temperatur eine monotektische Schmelze entsteht (U. Wiesner, G. Krabbes et al, Physica C 294 (1998) 17).

Es wurde auch schon gezeigt, dass die Stromdurchlässigkeit solcher Verbindungen signifikant höher ist als die der kohärenten Korngrenzen im Multiseed-Material (C. Harnois et al, EUCAS Europ. Conf. Applied Supercon., Copenhagen 29.8.2001, to be publ. in Physica C 2002). Die Nachteile dieser Verfahrensweise bestehen in der Fixierung der zu verbindenden Teile und des Lotmaterials, insbesondere beim Fügen von mehreren Einzelteilen. Der auf diese Weise supraleitend verbundene Formkörper hat bestenfalls die Größe des ursprünglichen Körpers. Ein Größenzuwachs durch Verbindung mehrerer Körner ist damit bisher nicht gelöst.

Aus dem Aufsatz von Y. A. Jee et al. in Supercond. Sci. Technol. 13 (2000) 195 ist ein hochtemperatursupraleitendes Bauteil gemäß dem Oberbegriff des Anspruchs 1 bekannt, bei dem nicht-supraleitende Fremdphasen im Korngrenzenbereich zwischen den HTSLSegmenten, die den Suprastrom stark herabsetzen, durch Modifizierung der Startzusammensetzung (z.B. Barium-Überschuss) oder spezielle Anordnung der Keimkristalle eliminiert oder reduziert werden.

Der Erfindung liegt die Aufgabe zugrunde, ein hochtemperatursupraleitendes massives Bauteil mit sehr guten, reproduzierbaren elektrischen und magnetischen Eigenschaften zu entwickeln. Eingeschlossen in diese Aufgabe ist die Entwicklung eines dementsprechenden Herstellungsverfahrens.

Bei der Lösung der Aufgabe wird von einem Bauteil ausgegangen, das aus einem Verbund mehrerer Supraleitersegmente besteht, die durch Schmelzkristallisation unter Auflage von jeweils einem Keimkristall erzeugt sind.

Das erfindungsgemäße Bauteil ist dadurch gekennzeichnet, dass die herstellungsbedingten kohärenten Korngrenzen zwischen den Supraleitersegmenten bis auf einen Steg entfernt sind und sich an Stelle des entfernten Korngrenzenmaterials ein weiteres, artverwandtes Supraleitermaterial befindet, welches einen niedrigeren Schmelzpunkt als das Segmentmaterial hat und welches die Supraleitersegmente miteinander verbindet.

Das weitere, artverwandte Supraleitermaterial kann auch aus einer Mischung artverwandter supraleitender Materialien bestehen.

Vorteilhafterweise ist das weitere, artverwandte Supraleitermaterial mit dem Segmentmaterial schmelzkristallin verbunden.

Die Hauptachsen des weiteren, artverwandten Supraleitermaterials weichen gegenüber den Hauptachsen des Segmentmaterials um einen Winkel von höchstens 10° voneinander ab.

zweckmäßigerweise hat das weitere, artverwandte supraleitende Material zwischen den Segmenten eine Dicke im Bereich von 0,1 bis 1,5 mm.

Vorzugsweise können die Supraleitersegmente aus YBa₂Cu₃O₇ und das weitere, artverwandte Supraleitermaterial aus SEBa₂Cu₃O₇ bestehen, wobei SE insbesondere Er, Ho, Yb oder Tm ist.

Im Material der Supraleitersegmente können Pt, CeO₂ SnO₂ und/oder ZnO als Zusätze enthalten sein.

Das weitere, artverwandte Supraleitermaterial kann vorteilhaft dotierende Elemente ,insbesondere Ca, zur Erhöhung der supraleitenden Stromdichte enthalten.

Das weitere, artverwandte Supraleitermaterial besteht vorteilhaft aus einem Verbundmaterial, das mindestens die Komponenten YBa₂Cu₃O_{7-δ} + nAg + mRE₂ₖBaₖCuₖO₅ₖ enthält, wobei n eine Größe zwischen 0,2 und 2 Mol und das Produkt mxk eine Größe zwischen 0,05 und 0,7 Mol ist, jeweils bezogen auf 1 Mol YBa₂Cu₃O_{7-δ} und mit k=1 oder k=2. Darin bezeichnet RE eines oder mehrere der Elemente Y, La oder der Lanthaniden.

Das zur Herstellung solcher Bauteile entwickelte Verfahren ist dadurch gekennzeichnet, dass zunächst in bekannter Weise durch Schmelzkristallisation unter Auflegen von Keimkristallen ein aus Supraleitersegmenten bestehender Körper hergestellt wird, danach die zwischen den Segmenten vorhandenen kohärenten Korngrenzen bis auf einen, den Zusammenhalt der Segmente sichernden Steg entfernt werden, danach an die Stellen der entfernten Korngrenzen ein weiteres, artgleiches Supraleitermaterial eingebracht wird, danach der Körper einer Schmelzkristallisationsbehandlung unterworfen wird und dass abschließend der Körper einer Oxidationsbehandlung zum Einstellen der Supraleitereigenschaften unterworfen wird.

Das Entfernen der Korngrenzen kann zweckmäßigerweise mittels mechanischem Materialabtrag erfolgen.

Die Schmelzkristallisationsbehandlung wird vor der Oxidationsbehandlung bei einer Temperatur durchgeführt, welche die Schmelztemperatur der Supraleitersegmente nicht übersteigt.

Bei der Herstellung des artgleichen Supraleitermaterials kann vorteilhaft CaCO₃ oder CaO in Anteilen von 0,01 bis 0,5 Masse% zugesetzt werden.

Die erfindungsgemäßen hochtemperatur-supraleitenden massiven Bauteile weisen sehr gute reproduzierbare elektrische und magnetische Eigenschaften auf.

Das an den Bauteilen messbare Remanenzfeld zeigt bei 77 K einen abgeflachten kegelförmigen Feldverlauf, bei dem über der Verbindungsstelle hohe Felder bestehen. Im Unterschied dazu zeigen herkömmlich hergestellte Bauteile ein stark gewellte Kontur des Remanenzfeld mit einem tiefen Minimum an der Verbindungsstelle.

Ein besonderer Vorteil besteht darin, dass die Folgen einer verfahrensbedingten lokalen Störung der Orientierungsbeziehung im Kleinwinkelbereich erfindungsgemäß durch eine lokale Dotierung an den Verbindungsstellen der Kristalle, beispielsweise mit Ca²⁺, ausgeglichen werden können.

Nachstehend ist die Erfindung an Ausführungsbeispielen näher erläutert. Die Beispiele betreffen verschiedene hochtemperatursupraleitende Bauteile und deren Herstellungsweise. Die Herstellung erfolgt bei allen Beispielen grundsätzlich in einem aus den folgenden Stufen bestehenden Grundprozess:
A. Herstellung eines Rohkörpers bestehend aus mehreren orientiert verwachsenen Segmenten mit kohärenten Korngrenzen nach einem an sich bekannten Verfahren, beispielsweise nach DE 297 23 453 U1,
B. Entfernen des mit Gefügestörungen behafteten Bereiches an den kohärenten Korngrenzen zwischen den Segmenten,
C. spezielle Wärmebehandlung zur Fertigstellung des erfindungsgemäßen Bauteils.

### Beispiel 1

Zur Herstellung eines Rohkörpers werden zu kommerziell erhältlichem YBa₂Cu₃O₇-HTSL Pulver 24 Mol% Y₂O₃ und 2 Mol% Pt oder die entsprechende Menge einer Pt-haltigen Verbindung beigemischt. Die Pulvermischung wird gemahlen und zu rechtwinkligen Platten der Form a = 60 mm, b = 30 mm, h = 15 mm uniaxial verpresst.

Auf die Platten werden jeweils zwei etwa 2 x 2 x 0,5 mm große sogenannte Sm-123 Keime aufgelegt, die aus SmBa₂Cu₃O₇ bestehen. Beim Auflegen werden die Keime bezüglich der Keimoberfläche [001] orientiert und mit der [100] - bzw. [010]-Achse entlang der äußeren Kanten der Platte ausgerichtet. Der Abstand zwischen den Keimen wird doppelt so groß wie zu den Kanten der Platte gewählt. Dadurch wird sichergestellt, daß ausgehend von beiden Keimen ein gleich großes Einzelsegment wachsen kann, mit einer gemeinsamen Korngrenze in der Mitte der Platte.

Die Platten werden mit 200 K/h auf 1030 °C aufgeheizt, 30 min auf dieser Temperatur gehalten und durch Abkühlen mit 0,6 K/h auf 940 °C in einem Ofen mit isothermen Temperaturprofil (± 1 K) schmelzkristallisiert.

Das erhaltene Gefüge besteht aus zwei Einzelsegmenten, die ausgehend von den Keimen symmetrisch bis an den Rand der Platte gewachsen sind. In der Mitte der Platte besteht eine kohärente Korngrenze.

Entlang der zwischen den orientierten Segmenten deutlich sichtbaren kohärenten Korngrenzen wird ein Spalt der Dicke D = 0,5 mm ohne Verwendung eines Schmiermittels herausgefräst, so dass nur ein schmaler Steg den mechanischen Zusammenhalt gewährleistet. In den Spalt wird eine Scheibe des artverwandten Lotmaterials passend eingefügt, welche zuvor aus einem ebenfalls durch einen Schmelzkristallisationsprozess hergestellten Block, der aus einer orientiert gewachsenen YBa₂Cu₃O_{7-δ}-Matrix und eingelagerten Partikeln von Y₂BaCuO₅ und Silberpartikeln besteht, herausgeschnitten wurde.

Zur Herstellung des verwendeten artverwandten Lotmaterials wird wie folgt vorgegangen:

1 Mol eines kommerziellen YBa₂Cu₃O₇-Pulvers wird mit 0,395 Mol Y₂O₃, 0,02 Mol Pt und 0,5 Mol Ag₂O innig vermischt. Die Mischung wird zu Platten von 40 x 40 x 22 mm³ verpresst, auf die ein Keimkristall aus SmBa₂Cu₃O₇ gelegt wird, und anschließend einem modifizierten Schmelzkristallisationsprozess in Luft unterworfen [P. Schätzle, G. Krabbes, S. Gruß, G. Fuchs, IEEE Trans. Appl. Supercond. 9 (1999) 2022]. Folgende Stufen werden mit den angegebenen Parametern durchlaufen: Aufheizen mit 400 K/h bis 1030 °C, 20 Minuten Haltezeit, schnell abkühlen auf 980 °C, darauf folgend langsam kühlen (1 K/h) auf 940 °C, anschließend mit 30 K/h bis Raumtemperatur. Aus dem entstandenen Kompositmaterial, im wesentlichen bestehend aus einer YBa₂Cu₃O_{7-δ}-Matrix mit Einschlüssen von Y₂BaCuO₅ und metallischem Silber, werden die 0,5 mm dicken Scheiben vom Querschnitt 30 x 15 mm herausgetrennt, die als artverwandtes Lotmaterial in den geschlitzten Rohling eingesetzt werden.

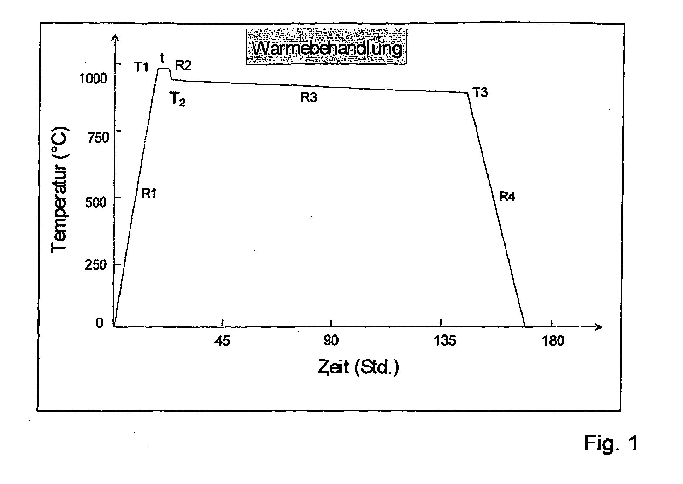

Die Stapelanordnung wird mittig in einem Rohrofen aufgestellt und einer erneuten Wärmebehandlung in Luft unterzogen. Das verwendete Temperatur-Zeitprogramm ist in Fig. 1 dargestellt.

Es werden dabei die folgenden Parameter gewählt:
Temperaturen T₁ = 995 °C
   T₂ = 973 °C
   T₃ = 943 °C
Rampen R₁ = 50 K/h
   R₂ = 100 K/h
   R₃ = 0,2 K/h
   R₄ = 50 K/h
Haltezeit t = 20 min

Während der kurzen Haltezeit t schmilzt das Lotmaterial monotektisch , wohingegen sich nur die Randbezirke der YBa₂Cu₃O₇-Segmente in der entstehenden Schmelze auflösen. Während des anschließenden langsamen Abkühlens kristallisiert die Lotphase in der von den supraleitenden Segmenten vorgegebenen Orientierung. Nach dem Abkühlen wird das entstandene Bauteil einem Oxidationsschritt in reinem Sauerstoff bei 400 °C unterzogen, wobei sich die für die Supraleitung notwendige orthorhombische Form der supraleitenden Verbindung YBa₂Cu₃O_{7-δ} (mit δ = 0,06) bildet.

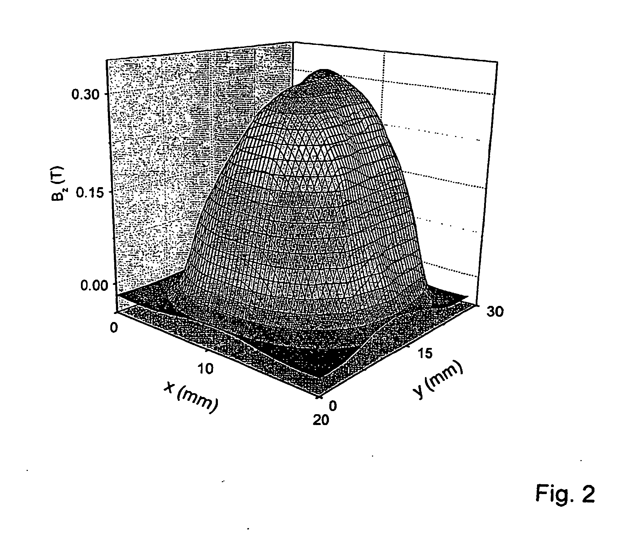

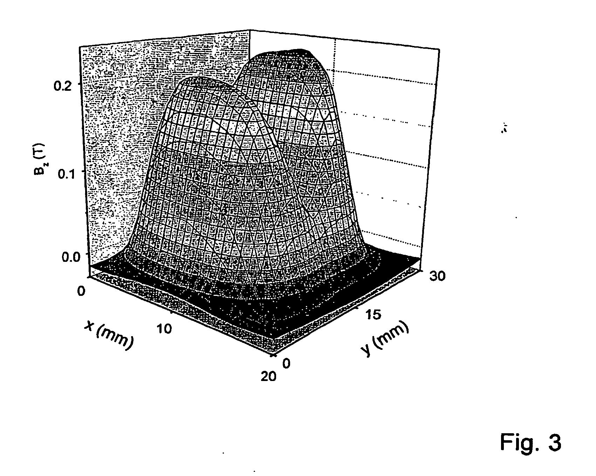

Die Messung des Remanenzfeldes mit der Hallsonde, zeigt bei 77 K einen abgeflachten kegelförmigen Feldverlauf, siehe Fig. 2, bei dem über der Verbindungsstelle hohe Felder bestehen. Den Unterschied dazu zeigt Fig. 3, in welcher der Feldverlauf der Probe im Rohzustand, die in vor der Messung der gleichen Sauerstoffbehandlung bei 400 °C unterzogen wurde wie die erfindungsgemäß behandelte Probe.

### Beispiel 2

Ein erfindungsgemäßes Bauteil wird, wie im Beispiel 1 ausführlich beschrieben, aber mit dem Unterschied hergestellt, dass das arteigene Lotmaterial aus einem Block herausgeschnitten wurde, der aus einer Matrix aus orientiert gewachsenem YbBa₂Cu₃O_{7-δ} besteht in die Partikel aus Yb₂BaCuO₅ eingelagert sind. Das arteigene Lotmaterial wird hergestellt durch einen Schmelzkristallisationsprozess ausgehend von einem Pressling aus einer Pulvermischung, die 1 Mol YbBa₂Cu₃O_{7-δ}, 0,33 Mol Yb₂BaCuO₅ und 0,02 Mol Pt enthält. Als Keimkristall wird SmBa₂Cu₃O₇ verwendet. Für die spezielle Wärmebehandlung im Schritt B werden im Beispiel 2 die folgenden Werte für die charakteristischen Parameter angewendet:
Temperaturen T₁ = 995 °C
   T₂ = 985 °C
   T₃ = 945 °C
Rampen R₁ = 50 K/h
   R₂ = 100 K/h
   R₃ = 0,3 K/h
   R₄ = 50 K/h
Haltezeit t = 1 h

Nach der abschließenden Oxidation in fließendem Sauerstoff bei 400 °C wird ein Material erhalten, dessen Remanenzinduktion nach Magnetisieren in flüssigem Stickstoff die Form eines abgeflachten Kegels aufweist und - im Unterschied zu dem Rohling - keinen Abfall der Magnetisierung entlang der ursprünglichen Korngrenze erkennen lässt.

### Vergleichsbeispiel

Ein Bauteil wird, wie im Beispiel 1 ausführlich beschrieben, aber mit dem Unterschied hergestellt, dass das Material im Bereich der kohärenten Korngrenze zwischen den Blöcken des Rohlings vollständig herausgetrennt wird. Zwischen die vereinzelten Blöcke wird eine Scheibe des artverwandten Lotmaterials, eines YBa₂Cu₃O₇/Ag Verbundmaterials (siehe Beispiel 1) mit gleicher kristallographischer Orientierung derart angeordnet, dass die zuvor kohärent zueinander gewachsenen Korngrenzen des Rohmaterials einander gegenüberstehen und der Stapel durch eine Klammerung aus temperaturresistentem Stahl zusammengehalten wird. Anschließend wird der Stapel der gleichen thermischen Behandlung unterworfen, wie im Beispiel 1 beschrieben.

## Patentansprüche

1. Hochtemperatursupraleitendes Bauteil, bestehend aus einem Verbund mehrerer Supraleitersegmente, die durch Schmelzkristallisation unter Auflage von jeweils einem Keimkristall erzeugt sind, **dadurch gekennzeichnet, dass** die herstellungsbedingten kohärenten Korngrenzen zwischen den Supraleitersegmenten bis auf einen Steg entfernt sind und sich an Stelle des entfernten Korngrenzenmaterials ein weiteres, artverwandtes Supraleitermaterial befindet, welches einen niedrigeren Schmelzpunkt als das Segmentmaterial hat und welches die Supraleitersegmente miteinander verbindet.

2. Bauteil nach Anspruch 1, **dadurch gekennzeichnet, dass** das weitere, artverwandte Supraleitermaterial aus einer Mischung artverwandter supraleitender Materialien besteht.

3. Bauteil nach Anspruch 1, **dadurch gekennzeichnet, dass** das weitere, artverwandte Supraleitermaterial mit dem Segmentmaterial schmelzkristallin verbunden ist.

4. Bauteil nach Anspruch 1, **dadurch gekennzeichnet, dass** die Hauptachsen des weiteren, artverwandten Supraleitermaterials gegenüber den Hauptachsen des Segmentmaterials um einen Winkel von höchstens 10° voneinander abweichen.

5. Bauteil nach Anspruch 1, **dadurch gekennzeichnet, dass** das weitere, artverwandte supraleitende Material mit einer Dicke im Bereich von 0,1 bis 1,5 mm zwischen den Segmenten vorliegt.

6. Bauteil nach Anspruch 1, **dadurch gekennzeichnet, dass** die Supraleitersegmente aus YBa₂Cu₃O₇ und das weitere, artverwandte Supraleitermaterial aus SEBa₂Cu₃O₇ besteht, wobei SE insbesondere Er, Ho, Yb oder Tm ist.

7. Bauteil nach Anspruch 1, **dadurch gekennzeichnet, dass** im Material der Supraleitersegmente Pt, CeO₂ SnO₂ und/oder ZnO als Zusätze enthalten sind.

8. Bauteil nach Anspruch 1, **dadurch gekennzeichnet, dass** das weitere, artverwandte Supraleitermaterial dotierende Elemente ,insbesondere Ca, zur Erhöhung der supraleitenden Stromdichte enthält.

9. Bauteil nach Anspruch 1, **dadurch gekennzeichnet, dass** das weitere, artverwandte Supraleitermaterial aus einem Verbundmaterial besteht, das mindestens die Komponenten YBa₂Cu₃O_{7-δ} + nAg + mRE₂ₖBaₖCuₖO₅ₖ enthält, wobei n eine Größe zwischen 0,2 und 2 Mol und das Produkt mxk eine Größe zwischen 0,05 und 0,7 Mol ist, jeweils bezogen auf 1 Mol YBa₂Cu₃O_{7-δ} und mit k=1 oder k=2, und wobei RE eines oder mehrere der Elemente Y, La oder der Lanthaniden bezeichnet.

10. Verfahren zur Herstellung eines hochtemperatur-supraleitenden Bauteils nach Anspruch 1, **dadurch gekennzeichnet, dass** zunächst in bekannter Weise durch Schmelzkristallisation unter Auflegen von Keimkristallen ein aus Supraleitersegmenten bestehender Körper hergestellt wird, danach die zwischen den Segmenten vorhandenen kohärenten Korngrenzen bis auf einen, den Zusammenhalt der Segmente sichernden Steg entfernt werden, danach an die Stellen der entfernten Korngrenzen ein weiteres, artgleiches Supraleitermaterial eingebracht wird, danach der Körper einer Schmelzkristallisationsbehandlung unterworfen wird und dass abschließend der Körper einer Oxidationsbehandlung zum Einstellen der Supraleitereigenschaften unterworfen wird.

11. Verfahren nach Anspruch 10, **dadurch gekennzeichnet, dass** das Entfernen der Korngrenzen mittels mechanischem Materialabtrag erfolgt.

12. Verfahren nach Anspruch 10, **dadurch gekennzeichnet, dass** die Schmelzkristallisationsbehandlung vor der Oxidationsbehandlung bei einer Temperatur durchgeführt wird, welche die Schmelztemperatur der Supraleitersegmente nicht übersteigt.

13. Verfahren nach Anspruch 10, **dadurch gekennzeichnet, dass** dem artgleichen Supraleitermaterial bei dessen Herstellung CaCO₃ oder CaO in Anteilen von 0,01 bis 0,5 Masse% zugesetzt werden.

## Claims

1. High-temperature superconducting component, consisting of a composite of a plurality of superconductor segments which are generated by melt crystallization respectively with the application of at least one seed crystal, **characterized in that** the production-related coherent grain boundaries between the superconductor segments are removed except on one portion and a further related type of superconductor material, which has a lower melting temperature than the segment material and which bonds the superconductor segments to one another, lies at the position of the removed grain boundary material.

2. Component according to Claim 1, **characterized in that** the further related type of superconductor material consists of a mixture of related types of superconductor materials.

3. Component according to Claim 1, **characterized in that** the further related type of superconductor material is melt-crystalline bonded to the segment material.

4. Component according to Claim 1, **characterized in that** the principal axes of the further related type of superconductor material deviate from one another by an angle of at most 10° relative to the principal axes of the segment material.

5. Component according to Claim 1, **characterized in that** the further related type of superconductor material is present with a thickness in the range of from 0.1 to 1.5 mm between the segments.

6. Component according to Claim 1, **characterized in that** the superconductor segments consist of YBa₂Cu₃O₇ and the further related type of superconductor material consists of SEBa₂Cu₃O₇, where SE is in particular Er, Ho, Yb or Tm.

7. Component according to Claim 1, **characterized in that** material of the superconductor segments contains Pt, CeO₂, SnO₂ and/or ZnO as additives.

8. Component according to Claim 1, **characterized in that** the further related type of superconductor material contains doping elements, in particular Ca, to increase the superconducting current density.

9. Component according to Claim 1, **characterized in that** the further related type of superconductor material consists of a composite material which contains at least the components YBa₂Cu₃O_{7-δ} + nAg + mRE₂ₖBaₖCuₖO₅ₖ, where n is a value between 0.2 and 2 moles and the product mxk is a value between 0.05 and 0.7 mole, respectively expressed in terms of 1 mole of YBa₂Cu₃O_{7-δ} and with k=1 or k=2, and where RE denotes one or more of the elements Y, La or the lanthanides.

10. Method for producing a high-temperature superconducting component according to Claim 1, **characterized in that** a body consisting of superconductor segments is first produced in a known way by melt crystallization with the application of seed crystals, then the coherent grain boundaries present between the segments are removed except on a portion which holds the segments together, then a further related type of superconductor material is introduced at the positions of the removed grain boundaries, then the body is subjected to a melt crystallization treatment, and **in that** the body is subsequently subjected to an oxidation treatment in order to adjust the superconductor properties.

11. Method according to Claim 10, **characterized in that** the grain boundaries are removed by means of mechanical material erosion.

12. Method according to Claim 10, **characterized in that** the melt crystallization treatment is carried out before the oxidation treatment at a temperature which does not exceed the melting temperature of the superconductor segments.

13. Method according to Claim 10, **characterized in that** CaCO₃ or CaO are added to the related type of superconductor material in proportions of from 0.01 to 0.5 mass% during its production.

## Revendications

1. Composant supraconducteur à haute température, constitué de l'assemblage de plusieurs segments supraconducteurs créés par cristallisation à l'état fondu en déposant sur chacun un cristal de germination, **caractérisé en ce que** les frontières cohérentes situées entre les grains des segments supraconducteurs et qui découlent de la préparation sont enlevées jusqu'à former un épaulement et **en ce qu'**à l'emplacement du matériau de frontières de grains enlevées est placé un autre matériau supraconducteur de nature similaire dont le point de fusion est plus bas que celui du matériau du segment et qui relie l'un à l'autre les segments supraconducteurs.

2. Composant selon la revendication 1, **caractérisé en ce que** l'autre matériau supraconducteur de nature similaire est constitué d'un mélange de matériaux supraconducteurs de nature similaire.

3. Composant selon la revendication 1, **caractérisé en ce que** l'autre matériau supraconducteur de nature similaire est relié au matériau des segments par cristallisation depuis l'état fondu.

4. Composant selon la revendication 1, **caractérisé en ce que** les axes principaux de l'autre matériau supraconducteur de nature similaire s'écartent des axes principaux du matériau du segment d'un angle d'au plus 10°.

5. Composant selon la revendication 1, **caractérisé en ce que** l'autre matériau supraconducteur de nature similaire est présent entre les segments à une épaisseur comprise entre 0,1 et 1,5 mm.

6. Composant selon la revendication 1, **caractérisé en ce que** les segments supraconducteurs sont constitués de YBa₂Cu₃O₇ et **en ce que** l'autre matériau supraconducteur de nature similaire est constitué de SEBa₂Cu₃O₇, SE représentant en particulier Er, Ho, Yb ou Tm.

7. Composant selon la revendication 1, **caractérisé en ce que** le matériau des segments supraconducteurs contient en supplément Pt, CeO₂, SnO₂ et/ou ZnO comme additifs.

8. Composant selon la revendication 1, **caractérisé en ce que** pour augmenter la densité de courant supraconducteur, l'autre matériau supraconducteur de nature similaire contient des éléments dopants, en particulier du Ca.

9. Composant selon la revendication 1, **caractérisé en ce que** l'autre matériau supraconducteur de nature similaire est constitué d'un matériau composite qui contient au moins les composants YBa₂Cu₃O_{7-δ} + nAg + mRE₂ₖBaₖCuₖO₅ₖ, n représentant une valeur comprise entre 0,2 et 2 moles et le produit m x k ayant une valeur comprise entre 0,05 et 0,7 mole, chaque fois par rapport à 1 mole de YBa₂Cu₃O_{7-δ}, avec k = 1 ou k = 2, RE représentant un ou plusieurs des éléments Y, La ou des lanthanides.

10. Procédé de fabrication d'un composant supraconducteur à haute température selon la revendication 1, **caractérisé en ce que** d'abord et de manière connue, on prépare un corps constitué de segments supraconducteurs par cristallisation à l'état fondu avec application de cristaux de germination, **en ce qu'**ensuite les frontières cohérentes entre les grains des segments sont enlevées jusqu'à former un épaulement qui assure le maintien des segments ensemble, **en ce qu'**ensuite aux emplacements où les frontières des grains ont été enlevées, on applique un autre matériau supraconducteur de nature similaire, **en ce qu'**ensuite le corps subit un traitement de cristallisation depuis l'état fondu et **en ce qu'**enfin le corps subit un traitement d'oxydation pour établir ses propriétés supraconductrices.

11. Procédé selon les revendications 10, **caractérisé en ce que** l'élimination des frontières des grains s'effectue par enlèvement mécanique de matière.

12. Procédé selon la revendication 10, **caractérisé en ce que** le traitement de cristallisation depuis l'état fondu qui précède le traitement d'oxydation est réalisé à une température qui ne dépasse pas la température de fusion des segments supraconducteurs.

13. Procédé selon la revendication 10, **caractérisé en ce que** lors de la préparation du matériau supraconducteur de nature similaire, on y ajoute du CaCO₃ ou du CaO à des teneurs comprises entre 0,01 et 0,5 % en masse.
